# EUROPEAN PATENT APPLICATION

(11) **EP 4 556 924 A1**
(43) Date of publication of application: **21.05.2025**
(21) Application number: 23907902.3
(22) Date of filing: 22.12.2023
(51) Int. Cl.: G01R 31/396, G01R 31/382, G01R 31/385, G01R 19/00

(54) **APPARATUS AND METHOD FOR MANAGING BATTERY**

(30) Priority: 23.12.2022 KR 20220183777
(71) Applicant: LG Energy Solution, Ltd., Seoul 07335 (KR)
(72) Inventor: KIM, Seung-Hyun, Daejeon 34122 (KR); SHIN, Chae-Bin, Daejeon 34122 (KR); LEE, Hyun-Chul, Daejeon 34122 (KR); KWON, Dong-Keun, Daejeon 34122 (KR)
(74) Representative: Plasseraud IP
(86) International application number: PCT/KR2023/021513
(87) International publication number: WO 2024/136619

(57) **Abstract**

A battery management apparatus according to an embodiment of the present disclosure includes a measurement unit configured to measure a charging amount and a discharging amount of a battery and measure a voltage of the battery; and a control unit configured to determine a charging and discharging state of the battery based on a charging and discharging amount according to the charging amount and the discharging amount, determine a first SOC and a second SOC corresponding to the voltage based on a profile corresponding to the determined charging and discharging state, and estimate a SOC of the battery from the first SOC and the second SOC using a weight corresponding to the charging and discharging amount.

## Description

### TECHNICAL FIELD

The present application claims priority to Korean Patent Application No. 10-2022-0183777 filed on December 23, 2022 in the Republic of Korea, the disclosures of which are incorporated herein by reference.

The present disclosure relates to a battery management apparatus and method, and more particularly, to a battery management apparatus and method capable of estimating a SOC (State of Charge) of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

In order to operate the battery efficiently and safely, the SOC (State of Charge) of the battery must be accurately estimated. Several techniques for estimation of SOC are known. A representative technique is to obtain the SOC corresponding to the OCV of the battery from a pre-given OCV-SOC profile as the corresponding relationship between the OCV (Open Circuit Voltage) and SOC of the battery.

A battery is used by repeatedly undergoing charging and discharging, which causes hysteresis in the battery in opposite directions. The charging profile is an OCV-SOC profile that represents the corresponding relationship between the OCV and SOC of the battery during charging. The discharging profile is an OCV-SOC profile that represents the corresponding relationship between the OCV and SOC of the battery during discharging.

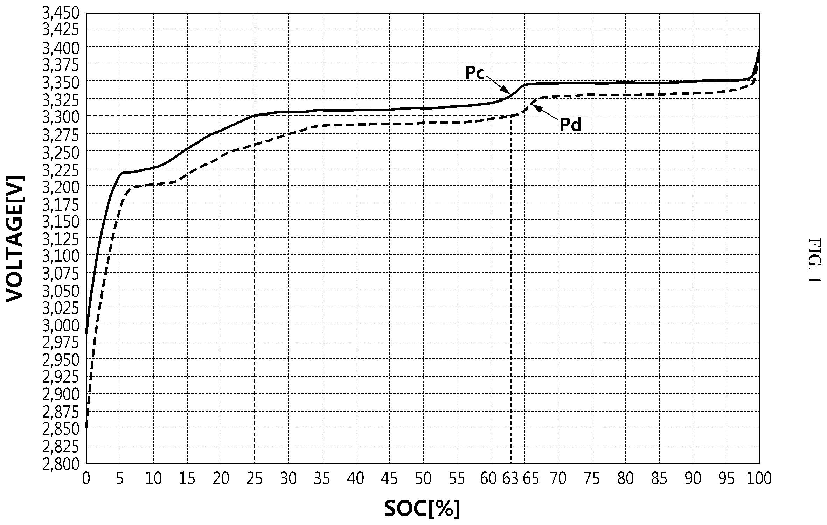

FIG. 1 is a diagram schematically showing a charging profile and a discharging profile of a battery. Specifically, FIG. 1 is a diagram schematically showing the charging profile and the discharging profile of an LFP (Lithium Iron Phosphate) battery, which has characteristics showing good hysteresis.

In the embodiment of FIG. 1, the SOC of the charging profile corresponding to voltage 3.3 [V] may be 25%, and the SOC of the discharging profile may be 63%. In other words, there is a problem where the SOC at the same voltage differs by about 38% due to hysteresis.

### DISCLOSURE

### Technical Problem

The present disclosure is designed to solve the problems of the related art, and therefore the present disclosure is directed to providing a battery management apparatus and method for estimating a SOC of a battery in consideration of charging and discharging hysteresis.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management apparatus according to one aspect of the present disclosure may comprise: a measurement unit configured to measure a charging amount and a discharging amount of a battery and measure a voltage of the battery; and a control unit configured to determine a charging and discharging state of the battery based on a charging and discharging amount according to the charging amount and the discharging amount, determine a first SOC and a second SOC corresponding to the voltage based on a profile corresponding to the determined charging and discharging state, and estimate a SOC of the battery from the first SOC and the second SOC using a weight corresponding to the charging and discharging amount.

The profile may include a charging profile corresponding to a first state and preset to represent the corresponding relationship between SOC and voltage; a discharging profile corresponding to a second state and preset to represent the corresponding relationship between SOC and voltage; and an average profile preset to represent an average voltage value for each SOC of the charging profile and the discharging profile.

The voltage for each SOC of the charging profile may be set to be higher than or equal to the voltage for each SOC of the discharging profile.

The control unit may be configured to determine the first SOC corresponding to the voltage of the battery using the charging profile or the discharging profile according to the charging and discharging state and determine the second SOC corresponding to the voltage of the battery using the average profile.

The control unit may be configured to calculate a first weight and a second weight by calculating the ratio of a preset reference amount and the charging and discharging amount and estimate the SOC of the battery by adding the first weight and the second weight to the first SOC and the second SOC, respectively.

When the charging and discharging amount is less than the reference amount, the control unit may be configured to estimate the SOC of the battery using the charging profile and the average profile or the discharging profile and the average profile according to the charging and discharging state of the battery.

When the charging and discharging amount is greater than or equal to the reference amount, the control unit may be configured to estimate the SOC of the battery using the charging profile or the discharging profile according to the charging and discharging state of the battery.

The reference amount may be preset as a SOC included in a SOC section in which a lower limit value is a SOC at which a change rate of the voltage for the SOC of the charging profile is less than a preset threshold value and an upper limit value is a SOC at which the change rate of the discharging profile is less than the threshold value.

The control unit may be configured to estimate the SOC of the battery by summing a value obtained by adding the first weight to the first SOC and a value obtained by adding the second weight to the second SOC.

The control unit may be configured to calculate the ratio of the charging and discharging amount to the reference amount as the first weight and calculate the complement of 1 of the first weight as the second weight.

The control unit may be configured to calculate the charging and discharging amount by calculating the difference between the charging amount and the discharging amount, and determine the charging and discharging state of the battery as the first state or the second state based on the calculated charging and discharging amount.

A battery pack according to another aspect of the present disclosure may comprise the battery management apparatus according to an aspect of the present disclosure.

An energy storage system according to still another aspect of the present disclosure may comprise the battery management apparatus according to an aspect of the present disclosure.

A battery management method according to still another aspect of the present disclosure may comprise: a current measuring step of measuring a charging amount and a discharging amount of a battery; a voltage measuring step of measuring a voltage of the battery; a charging and discharging state determining step of determining a charging and discharging state of the battery based on a charging and discharging amount according to the charging amount and the discharging amount; a SOC determining step of determining a first SOC and a second SOC corresponding to the voltage based on a profile corresponding to the determined charging and discharging state; and a SOC estimating step of estimating a SOC of the battery from the first SOC and the second SOC using a weight corresponding to the charging and discharging amount.

### Advantageous Effects

According to one aspect of the present disclosure, the battery management apparatus has the advantage of being able to more accurately estimate the SOC of the battery by considering the charging and discharging state of the battery and the hysteresis of the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing a charging profile and a discharging profile of a battery.
FIG. 2 is a diagram schematically showing a battery management apparatus according to an embodiment of the present disclosure.
FIG. 3 is a drawing schematically showing a profile according to an embodiment of the present disclosure.
FIG. 4 is a diagram showing a SOC section preset in the profile according to an embodiment of the present disclosure.
FIG. 5 is a diagram schematically showing an exemplary configuration of a battery pack according to another embodiment of the present disclosure.
FIG. 6 is a diagram schematically showing a vehicle according to still another embodiment of the present disclosure.
FIG. 7 is a diagram schematically showing an energy storage system according to still another embodiment of the present disclosure.
FIG. 8 is a diagram schematically showing a battery management method according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

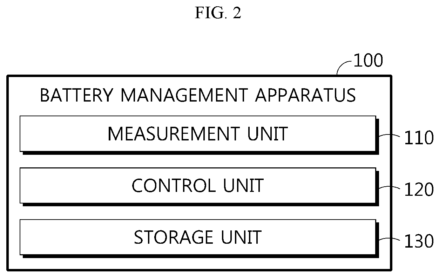

FIG. 2 is a diagram schematically showing a battery management apparatus 100 according to an embodiment of the present disclosure.

Referring to FIG. 2, the battery management apparatus 100 may be configured to include a measurement unit 110 and a control unit 120.

Here, the battery means one physically separable independent cell including a negative electrode terminal and a positive electrode terminal. For example, one lithium-ion battery or lithium polymer battery may be regarded as a battery. Hereinafter, for convenience of explanation, the battery is explained as meaning one independent cell.

The measurement unit 110 may be configured to measure the charging amount and discharging amount of the battery.

Specifically, the measurement unit 110 may measure the charging current and discharging current for the battery. Additionally, the measurement unit 110 may measure the charging amount of the battery based on the charging current amount during the charging process. Likewise, the measurement unit 110 may measure the discharging amount of the battery based on the discharging current amount during the discharging process.

The measurement unit 110 may be configured to measure the voltage of the battery.

Specifically, the measurement unit 110 may measure the voltage at both ends of the battery. For example, the measurement unit 110 may measure the battery voltage by measuring the positive electrode voltage and negative electrode voltage of the battery and calculating the difference between the positive electrode voltage and negative electrode voltage.

Preferably, the measurement unit 110 may measure the OCV of the battery. Here, the OCV refers to a voltage of the battery when the battery is maintained in a no-load state for a predetermined period of time. For example, the measurement unit 110 may measure the OCV when both charging and discharging of the battery are completed and the battery is maintained in a no-load state for a predetermined period of time.

The control unit 120 may be configured to determine the charging and discharging state of the battery based on the charging and discharging amount according to the charging amount and discharging amount.

Specifically, the control unit 120 may be configured to calculate the charging and discharging amount by calculating the difference between the charging amount and the discharging amount. Additionally, the control unit 120 may be configured to determine the charging and discharging state of the battery as the first state or the second state based on the calculated charging and discharging amount.

Here, the first state represents a state in which the battery is charged, and the second state represents a state in which the battery is discharged.

For example, when the charging amount exceeds the discharging amount, the control unit 120 may determine the charging and discharging state of the battery as the first state. Conversely, if the charging amount is less than the discharging amount, the control unit 120 may determine the charging and discharging state of the battery as the second state. That is, the control unit 120 may determine the charging and discharging state of the battery as the first state or the second state based on the difference between the total charging amount and the total discharging amount even if the charging and discharging of the battery is repeated.

The control unit 120 may be configured to determine the first SOC and second SOC corresponding to the voltage based on the profile corresponding to the determined charging and discharging state.

The profile may be preset to include a charging profile and a discharging profile. Here, the profile may be set in advance to represent the corresponding relationship between SOC and voltage. For example, if the X-axis is set to SOC and Y is set to voltage, the profile may be expressed as an X-Y graph.

Specifically, the charging profile is a profile corresponding to the first state of the battery and may be preset to represent the corresponding relationship between SOC and voltage. That is, the charging profile may be a profile corresponding to a charged battery.

Additionally, the discharging profile is a profile corresponding to the second state of the battery and may be preset to represent the corresponding relationship between SOC and voltage. In other words, the discharging profile may be a profile corresponding to a discharged battery.

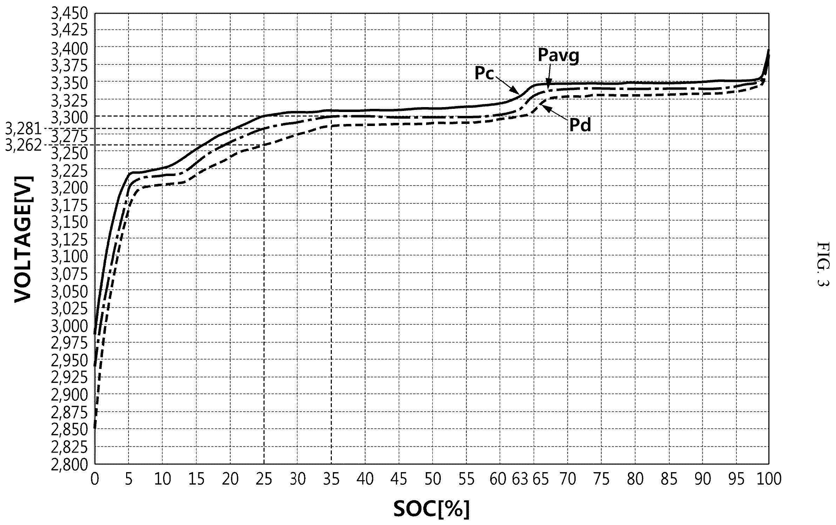

FIG. 3 is a drawing schematically showing a profile according to an embodiment of the present disclosure. Specifically, the embodiment of FIG. 3 is a diagram showing a charging profile Pc corresponding to the first state and a discharging profile Pd corresponding to the second state.

Preferably, the charging profile may be set so that the voltage for each SOC is higher than or equal to the voltage for each SOC of the discharging profile. For example, comparing the voltage corresponding to SOC 25% in the embodiment of FIG. 3, the voltage according to the charging profile Pc is 3.3 [V], and the voltage according to the discharging profile Pd is 3.262 [V]. The difference in voltage for each SOC between the charging profile Pc and the discharging profile Pd is due to the hysteresis of the battery.

The control unit 120 may select the charging profile or discharging profile according to the charging and discharging state of the battery. For example, if the control unit 120 determines the charging and discharging state of the battery as the first state, the control unit 120 may select the charging profile. Conversely, if the control unit 120 determines the charging and discharging state of the battery as the second state, the control unit 120 may select the discharging profile.

The control unit 120 may estimate the first SOC corresponding to the voltage based on the selected profile. For example, when the charging profile is selected, the control unit 120 may estimate the first SOC by substituting the measured voltage into the charging profile.

Also, the control unit 120 may estimate the second SOC corresponding to the voltage based on the charging profile and discharging profile. In other words, the second SOC may not be estimated based only on the charging profile or discharging profile, but may be estimated by considering both the charging profile and the discharging profile.

The control unit 120 may be configured to estimate the SOC of the battery from the first SOC and the second SOC using a weight corresponding to the charging and discharging amount.

Specifically, control unit 120 may add the weight to each of the first SOC and second SOC. In addition, the control unit 120 may estimate the final SOC for the battery by summing the first SOC to which the weight is added and the second SOC to which the weight is added.

For example, the first SOC is a SOC resulting from the charging profile or discharging profile selected according to the charging and discharging state of the battery. Also, the second SOC is unrelated to the charging and discharging state of the battery, and is a SOC caused by the charging profile and discharging profile. That is, the control unit 120 may estimate the first SOC by considering the charging and discharging state of the battery, and estimate the second SOC by considering the hysteresis of the battery. The final SOC of the battery may be estimated according to the first SOC and second SOC estimated in this way.

Therefore, the battery management apparatus 100 has the advantage of being able to more accurately estimate the SOC of the battery by considering the charging and discharging state of the battery and the hysteresis of the battery.

Meanwhile, the control unit 120 provided in the battery management apparatus 100 may selectively include processors known in the art, application-specific integrated circuits (ASICs), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its type as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the profile for the battery may be stored in advance in the storage unit 130. The control unit 120 may access the storage unit 130 to obtain the profile for the battery.

The profile may be preset to further include an average profile. That is, the profile may include a charging profile, a discharging profile, and an average profile.

The average profile may be preset to represent the average voltage value for each SOC of the charging profile and discharging profile.

For example, in the embodiment of FIG. 3, the average profile Pavg may be set to represent the average voltage value of the voltage for each SOC of the charging profile Pc and the voltage for each SOC of the discharging profile Pd. For example, comparing the voltage corresponding to SOC 25% in the embodiment of FIG. 3, the voltage according to the charging profile Pc is 3.3 [V], the voltage according to the discharging profile Pd is 3.262 [V], and the voltage according to the average profile Pavg is 3.281 [V]. In other words, the voltage 3.281 [V] according to the average profile Pavg may be the average value of the voltage 3.3 [V] according to the charging profile Pc and the voltage 3.262 [V] according to the discharging profile Pd.

The control unit 120 may be configured to determine the first SOC corresponding to the voltage of the battery using the charging profile or discharging profile according to the charging and discharging state.

For example, if the control unit 120 determines the charging and discharging state of the battery as the first state, the control unit 120 may estimate the first SOC by substituting the measured voltage into the charging profile. Conversely, if the control unit 120 determines the charging and discharging state of the battery as the second state, the control unit 120 may estimate the first SOC by substituting the measured voltage into the discharging profile.

The control unit 120 may be configured to determine the second SOC corresponding to the voltage of the battery using the average profile.

For example, the control unit 120 may estimate the second SOC by substituting the measured voltage into the average profile. That is, the control unit 120 may estimate the second SOC based on the average profile regardless of the charging and discharging state of the battery. In other words, the control unit 120 may estimate the second SOC corresponding to the voltage using the average profile set based on the charging profile and discharging profile.

Additionally, the control unit 120 may estimate the SOC of the battery using the first SOC estimated based on the charging profile or the discharging profile and the second SOC estimated based on the average profile. Through this, the battery management apparatus 100 has the advantage of being able to more accurately estimate the SOC of the battery by considering the hysteresis of the battery.

The control unit 120 may be configured to calculate the first weight and second weight by calculating the ratio of a preset reference amount and the charging and discharging amount.

Here, the ratio of the reference amount and the charging and discharging amount may be calculated according to the formula "charging and discharging amount ÷ reference amount".

Specifically, the control unit 120 may be configured to calculate the ratio of the charging and discharging amount to the reference amount as the first weight. Additionally, the control unit 120 may be configured to calculate the complement of 1 of the first weight as the second weight.

Here, the complement of 1 of the first weight may be calculated as the difference between 1 and the first weight. In other words, the complement of 1 of the first weight may be calculated according to the formula "1 - first weight". In other words, the sum of the first weight and the second weight may be 1.

The control unit 120 may be configured to estimate the SOC of the battery by adding the first weight and the second weight to the first SOC and the second SOC, respectively.

Specifically, the control unit 120 may be configured to estimate the SOC of the battery by summing a value obtained by adding the first weight to the first SOC and a value obtained by adding the second weight to the second SOC.

For example, the control unit 120 may estimate the SOC of the battery by calculating the formula "(first SOC × first weight) + (second SOC × second weight)".

The battery management apparatus 100 may estimate the SOC of the battery using the first SOC estimated due to the charging and discharging state of the battery and the second SOC estimated due to the hysteresis of the battery (estimated due to the average profile). That is, since the battery management apparatus 100 estimates the SOC of the battery by considering both the charging and discharging state and the hysteresis of the battery, it has the advantage of being able to more accurately estimate the SOC of the battery in which hysteresis appears. As the hysteresis increases, the SOC estimated by the battery management apparatus 100 may be significantly more accurate than the SOC estimated using only the charging profile or discharging profile.

In one embodiment, the reference amount may be a value set through experiment. For example, it is possible to increase the charging amount of the experimental battery and select a charging threshold SOC where the voltage for each SOC of the experimental battery and the voltage for each SOC of the charging profile are the same. In addition, it is possible to increase the discharging amount of the experimental battery and select a discharging threshold SOC where the voltage for each SOC of the experimental battery and the voltage for each SOC of the discharging profile are the same. Also, the larger value of the charging threshold SOC and the discharging threshold SOC may be set as the reference amount.

In another embodiment, the reference amount may be preset as a SOC included in the SOC section in which a lower limit value is a SOC at which the change rate of voltage for the SOC of the charging profile is less than a preset threshold value, and an upper limit value is a SOC at which the change rate of the discharging profile is less than the threshold value.

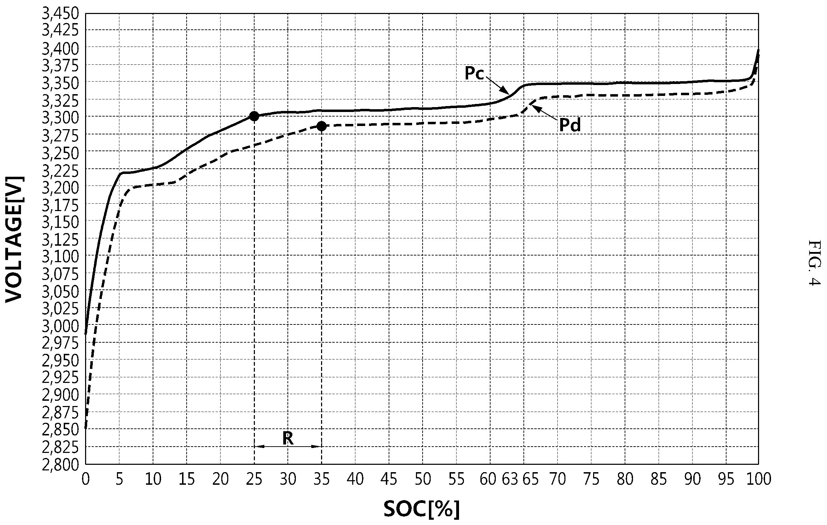

FIG. 4 is a diagram showing a SOC section preset in the profile according to an embodiment of the present disclosure.

Referring to FIG. 4, the change rate of voltage for SOC may indicate the slope of the profile. In other words, a section in which the change rate of voltage with respect to SOC is less than the threshold value means a section in which the change in voltage according to the change in SOC is insignificant. For example, this section is called a plateau section or a flat section, and has a characteristic that it is often seen in batteries with an olivine structure. For example, the plateau section may well appear in the charging and discharging profile of an LFP battery.

In the embodiment of FIG. 4, the plateau section of the charging profile Pc may have SOC of 25% to 60% and 65% to 98%. Also, the plateau section of the discharging profile Pd may have SOC of 35% to 63% and 67% to 98%. Here, the lower limit value of the SOC section R may correspond to SOC 25% at which the change rate of voltage for SOC of the charging profile Pc is less than the threshold value, and the upper limit value of the SOC section R may correspond to SOC 35% at which the change rate of voltage for SOC of the discharging profile Pd is less than the threshold value. Therefore, the SOC section R may be set to a section of SOC 25% to 35%.

Also, the reference amount may be set in advance to any one SOC belonging to the SOC section. That is, the reference amount may be selected between the starting SOC of the plateau section of the charging profile and the starting SOC of the plateau section of the discharging profile. For example, in the embodiment of FIG. 4, the reference amount may be set to SOC 30% included in SOC section R of SOC 25% or more and SOC 35% or less.

The control unit 120 may be configured to compare the charging and discharging amount and the reference amount and estimate the SOC of the battery based on the comparison result.

For example, if the charging and discharging amount is less than the reference amount, the control unit 120 may be configured to estimate the SOC of the battery using the charging profile and the average profile or the discharging profile and the average profile according to the charging and discharging state of the battery.

Here, if the charging and discharging amount is less than the reference amount, it means a state in which the voltage for each SOC of the battery has not converged to the charging profile or discharging profile. That is, if the charging and discharging amount is less than the reference amount, the voltage for each SOC of the battery may be located between the charging profile and the average profile or between the discharging profile and the average profile. Therefore, the control unit 120 may estimate the SOC of the battery based on the first SOC and the second SOC.

As another example, the control unit 120 may be configured to estimate the SOC of the battery using the charging profile or the discharging profile according to the charging and discharging state of the battery if the charging and discharging amount is greater than or equal to the reference amount.

If the charging and discharging amount is greater than or equal to the reference amount, it means that the voltage for each SOC of the battery has converged to the charging profile or discharging profile. That is, if the charging and discharging amount is greater than or equal to the reference amount, the voltage for each SOC of the battery may follow the charging profile or discharging profile. Accordingly, the control unit 120 may estimate the SOC of the battery based on the charging profile or discharging profile by considering the charging and discharging state of the battery. For example, control unit 120 may determine the first SOC to be the SOC of the battery.

According to the previous embodiment, the ratio of the reference amount and the charging and discharging amount may be calculated according to the formula "charging and discharging amount ÷ reference amount". For example, if the charging and discharging amount is greater than or equal to the reference amount, the ratio between the reference amount and the charging and discharging amount may be greater than or equal to 1. In this case, because the second weight is the complement of 1 of the first weight, the second weight may not be calculated. Therefore, if the charging and discharging amount is greater than or equal to the reference amount, the control unit 120 may estimate the first SOC as the SOC of the battery. Here, it should be noted that no first weight is added to the first SOC, and the first SOC is directly estimated as the SOC of the battery.

The battery management apparatus 100 may change the battery SOC estimation method by comparing the charging and discharging amount and the reference amount. That is, because the battery management apparatus 100 estimates the SOC of the battery using an appropriate method according to the current charging and discharging state of the battery, the accuracy and reliability of the estimated SOC may be improved.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the control unit 120 and the storage unit 130 may be implemented as components of the BMS.

The battery management apparatus 100 according to the present disclosure may be provided in a battery pack. That is, the battery pack according to the present disclosure may include the above-described battery management apparatus 100 and one or more battery cells. In addition, the battery pack may further include electrical equipment (relays, fuses, etc.) and a case.

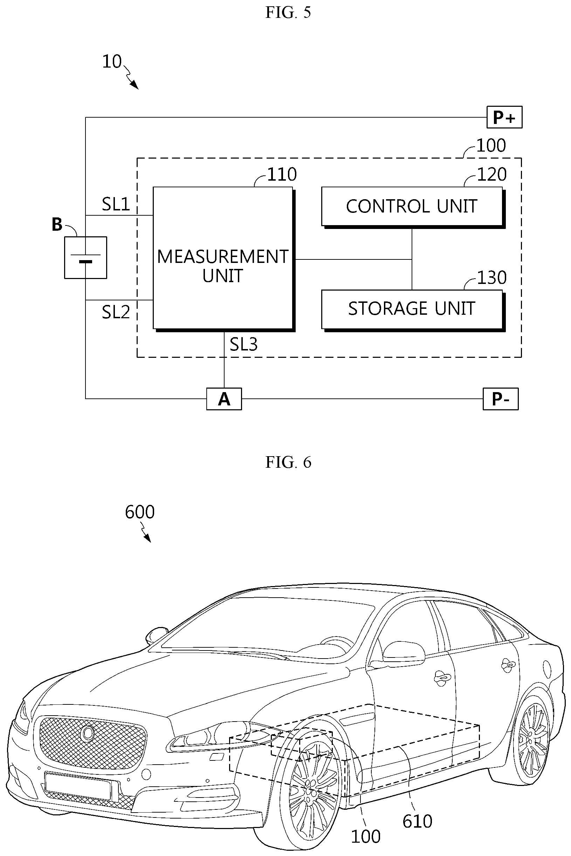

FIG. 5 is a diagram schematically showing an exemplary configuration of a battery pack 1 according to another embodiment of the present disclosure.

The positive electrode terminal of the battery B may be connected to the positive electrode terminal P+ of the battery pack 10, and the negative electrode terminal of the battery B may be connected to the negative electrode terminal P- of the battery pack 10.

A measurement unit 110 may be connected to a first sensing line SL1, a second sensing line SL2, and a third sensing line SL3. Specifically, the measurement unit 110 may be connected to a positive electrode terminal of the battery B through the first sensing line SL1, and may be connected to a negative electrode terminal of the battery B through the second sensing line SL2. The measurement unit 110 may measure the voltage of the battery B based on the voltage measured at each of the first sensing line SL1 and the second sensing line SL2.

In addition, the measurement unit 110 may be connected to an ampere meter A through the third sensing line SL3. For example, the ampere meter A may be an ammeter or a shunt resistor capable of measuring the charging current and the discharging current of the battery B. The measurement unit 110 may calculate the charge amount by measuring the charging current of the battery B through the third sensing line SL3. Also, the measurement unit 110 may calculate the discharge amount by measuring the discharge current of the battery B through the third sensing line SL3.

An external device may be connected to the positive electrode terminal P+ and the negative electrode terminal P- of the battery pack 10. The external device may be a charging and discharging device capable of charging the battery B. As another example, the external device may be a load that receives power from the battery B.

FIG. 6 is a diagram schematically showing a vehicle 600 according to still another embodiment of the present disclosure.

Referring to FIG. 6, the battery pack 610 according to an embodiment of the present disclosure may be included in a vehicle 600 such as an electric vehicle (EV) or a hybrid vehicle (HV). Additionally, the battery pack 610 may drive the vehicle 600 by supplying power to the motor through an inverter provided in the vehicle 600. Additionally, the battery pack 610 may include the battery management apparatus 100.

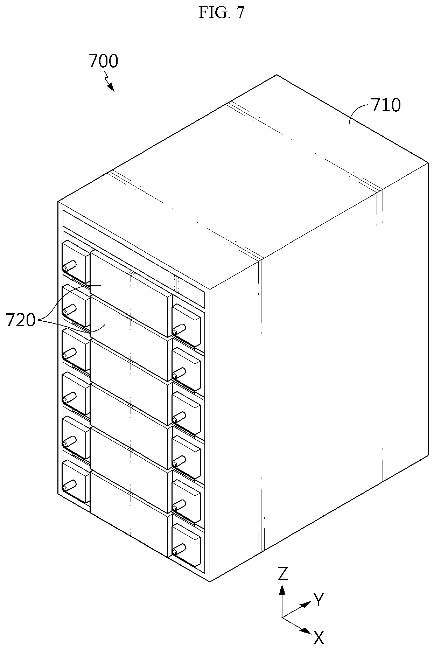

FIG. 7 is a diagram schematically showing an energy storage system (ESS) according to still another embodiment of the present disclosure.

Referring to FIG. 7, the energy storage system 700 includes a plurality of battery modules 720 and a rack case 710. The plurality of battery modules 720 may be configured to be accommodated in the rack case 710 in a vertically arranged form. Additionally, each battery module 720 may include the battery management apparatus 100.

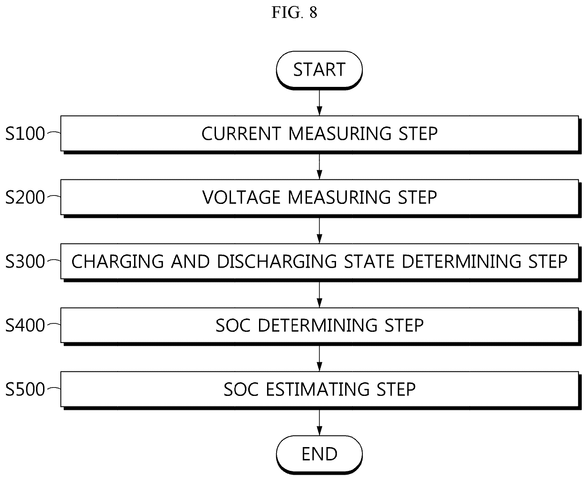

FIG. 8 is a diagram schematically showing a battery management method according to still another embodiment of the present disclosure.

Preferably, each step of the battery management method may be performed by the battery management apparatus 100. Hereinafter, for convenience of explanation, contents overlapping with the previously described contents will be omitted or briefly described.

Referring to FIG. 8, the battery management method may include a current measuring step (S100), a voltage measuring step (S200), a charging and discharging state determining step (S300), a SOC determining step (S400), and a SOC estimating step (S500).

The current measuring step (S100) is a step of measuring a charging amount and a discharging amount of a battery, and may be performed by the measurement unit 110.

For example, measurement unit 110 may measure the charging current and the discharging current for the battery. Additionally, the measurement unit 110 may measure the charging amount of the battery based on the charging current amount during the charging process. Likewise, the measurement unit 110 may measure the discharging amount of the battery based on the discharging current amount during the discharging process.

The voltage measuring step (S200) is a step of measuring a voltage of the battery, and may be performed by the measurement unit 110.

For example, the measurement unit 110 may measure the voltage of the battery by calculating the difference between the positive electrode voltage and negative electrode voltage. Preferably, the measurement unit 110 may measure the OCV of the battery.

The charging and discharging state determining step (S300) is a step of determining a charging and discharging state of the battery based on a charging and discharging amount according to the charging amount and the discharging amount, and may be performed by the control unit 120.

For example, the control unit 120 may be configured to calculate the charging and discharging amount by calculating the difference between the charging amount and the discharging amount. Additionally, the control unit 120 may be configured to determine the charging and discharging state of the battery as the first state or the second state based on the calculated charging and discharging amount. Here, the first state represents a state in which the battery is charged, and the second state represents a state in which the battery is discharged.

The SOC determining step (S400) is a step of determining a first SOC and a second SOC corresponding to the voltage based on a profile corresponding to the determined charging and discharging state, and may be performed by the control unit 120.

For example, if the control unit 120 determines the charging and discharging state of the battery as the first state, the control unit 120 may estimate the first SOC by substituting the measured voltage into the charging profile. Conversely, if the control unit 120 determines the charging and discharging state of the battery as the second state, the control unit 120 may estimate the first SOC by substituting the measured voltage into the discharging profile. Also, the control unit 120 may estimate the second SOC by substituting the measured voltage into the average profile.

The SOC estimating step (S500) is a step of estimating a SOC of the battery from the first SOC and the second SOC using a weight corresponding to the charging and discharging amount, and may be performed by the control unit 120.

For example, the control unit 120 may calculate the first weight and the second weight by calculating the ratio of the preset reference amount and the charging and discharging amount. The control unit 120 may add the weight to each of the first SOC and the second SOC. In addition, the control unit 120 may estimate the final SOC for the battery by summing the first SOC to which the weight is added and the second SOC to which the weight is added.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

10: battery pack
11: battery
100: battery management apparatus
110: measurement unit
120: control unit
130: storage unit
600: vehicle
610: battery pack
700: energy storage system
710: rack case
720: battery module

## Claims

1. A battery management apparatus, comprising:
a measurement unit configured to measure a charging amount and a discharging amount of a battery and measure a voltage of the battery; and
a control unit configured to determine a charging and discharging state of the battery based on a charging and discharging amount according to the charging amount and the discharging amount, determine a first SOC and a second SOC corresponding to the voltage based on a profile corresponding to the determined charging and discharging state, and estimate a SOC of the battery from the first SOC and the second SOC using a weight corresponding to the charging and discharging amount.

2. The battery management apparatus according to claim 1,
wherein the profile includes:
a charging profile corresponding to a first state and preset to represent the corresponding relationship between SOC and voltage;
a discharging profile corresponding to a second state and preset to represent the corresponding relationship between SOC and voltage; and
an average profile preset to represent an average voltage value for each SOC of the charging profile and the discharging profile.

3. The battery management apparatus according to claim 2,
wherein the voltage for each SOC of the charging profile is set to be higher than or equal to the voltage for each SOC of the discharging profile.

4. The battery management apparatus according to claim 2,
wherein the control unit is configured to determine the first SOC corresponding to the voltage of the battery using the charging profile or the discharging profile according to the charging and discharging state and determine the second SOC corresponding to the voltage of the battery using the average profile.

5. The battery management apparatus according to claim 2,
wherein the control unit is configured to calculate a first weight and a second weight by calculating the ratio of a preset reference amount and the charging and discharging amount and estimate the SOC of the battery by adding the first weight and the second weight to the first SOC and the second SOC, respectively.

6. The battery management apparatus according to claim 5,
wherein when the charging and discharging amount is less than the reference amount, the control unit is configured to estimate the SOC of the battery using the charging profile and the average profile or the discharging profile and the average profile according to the charging and discharging state of the battery.

7. The battery management apparatus according to claim 6,
wherein when the charging and discharging amount is greater than or equal to the reference amount, the control unit is configured to estimate the SOC of the battery using the charging profile or the discharging profile according to the charging and discharging state of the battery.

8. The battery management apparatus according to claim 5,
wherein the reference amount is preset as a SOC included in a SOC section in which a lower limit value is a SOC at which a change rate of the voltage for the SOC of the charging profile is less than a preset threshold value and an upper limit value is a SOC at which the change rate of the discharging profile is less than the threshold value.

9. The battery management apparatus according to claim 5,
wherein the control unit is configured to estimate the SOC of the battery by summing a value obtained by adding the first weight to the first SOC and a value obtained by adding the second weight to the second SOC.

10. The battery management apparatus according to claim 5,
wherein the control unit is configured to calculate the ratio of the charging and discharging amount to the reference amount as the first weight and calculate the complement of 1 of the first weight as the second weight.

11. The battery management apparatus according to claim 1,
wherein the control unit is configured to calculate the charging and discharging amount by calculating the difference between the charging amount and the discharging amount, and determine the charging and discharging state of the battery as the first state or the second state based on the calculated charging and discharging amount.

12. A battery pack, comprising the battery management apparatus according to any one of claims 1 to 11.

13. An energy storage system, comprising the battery management apparatus according to any one of claims 1 to 11.

14. A battery management method, comprising:
a current measuring step of measuring a charging amount and a discharging amount of a battery;
a voltage measuring step of measuring a voltage of the battery;
a charging and discharging state determining step of determining a charging and discharging state of the battery based on a charging and discharging amount according to the charging amount and the discharging amount;
a SOC determining step of determining a first SOC and a second SOC corresponding to the voltage based on a profile corresponding to the determined charging and discharging state; and
a SOC estimating step of estimating a SOC of the battery from the first SOC and the second SOC using a weight corresponding to the charging and discharging amount.
